(19)

Europäisches
Patentamt
European
Patent Office
Office européen
des brevets

(11) **EP 1 890 382 B1**

(12) **EUROPEAN PATENT SPECIFICATION**

(45) Date of publication and mention
of the grant of the patent:
**04.03.2009 Bulletin 2009/10**

(51) Int Cl.:
***H03L 7/00*** *(2006.01)*

(21) Application number: **06119151.6**

(22) Date of filing: **18.08.2006**

(54) **Phase locked loop with improved linearity**

Phasenregelschleife mit verbesserter Linearität

Boucle à verrouillage de phase avec linearité améliorée

(84) Designated Contracting States:
**AT BE BG CH CY CZ DE DK EE ES FI FR GB GR
HU IE IS IT LI LT LU LV MC NL PL PT RO SE SI
SK TR**

(43) Date of publication of application:
**20.02.2008 Bulletin 2008/08**

(73) Proprietor: **SiTel Semiconductor B.V.
5215 MV 's-Hertogenbosch (NL)**

(72) Inventor: **Prummel, Jan Geert
5614 HS Eindhoven (NL)**

(74) Representative: **van Westenbrugge, Andries
Nederlandsch Octrooibureau
Postbus 29720
2502 LS Den Haag (NL)**

(56) References cited:
**JP-A- 5 114 858          JP-A- 6 090 116
JP-A- 11 215 112          US-A1- 2003 098 745**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**EP 1 890 382 B1**

**Description**

**Field of the invention**

The present invention relates to a phase locked loop (PLL). More in particular, the present invention relates to a phase locked loop circuit for relating a reference signal phase $\theta_R$ with an output signal phase $\theta_0$, comprising a frequency divider receiving the output signal as input and providing a divided frequency signal with a divided frequency signal phase $\theta_N$ as output using a divide ratio N, N being a rational number, a phase comparator for providing a phase difference $\theta_D$ between the reference signal phase $\theta_R$ and the divided frequency signal phase $\theta_N$, a first transfer block having a detector gain Kd receiving the phase difference $\theta_D$ as input, a second transfer block having a transfer function F(s) connected to the first transfer block, and a third transfer block having a transfer function equal to $\dfrac{Kv}{s}$ and connected to the second transfer block for outputting the output signal phase $\theta_0$, Kv being a tuning constant. It is noted that in actual implementations, the frequency divider may be provided as an N-counter or digital counter, which is only able to divide by integer numbers of N. However, schemes may be used with a varying integer value of the divide ratio N over time, resulting in a mean value of the divide ratio N over time which is a rational number.

**Prior art**

Such a phase locked loop circuit is known from e.g. international patent application WO2004/051854, which discloses a phase locked loop with a forward path and a feedback path. In the forward path, an oscillator is driven by a phase detector, and in the feedback path, a frequency divider connects the oscillator output with the phase detector. In this document, furthermore an integrator free loop filter is present to control the oscillator.
Furthermore, American patent application US2006/139109 discloses a frequency synthesizer with a phase locked loop. The phase locked loop comprises an oscillator, a variable frequency divider, a phase comparator, and a loop filter to control the oscillator. The loop filter disclosed is a fractional order low pass filter.

**Summary of the invention**

For certain applications, it is necessary to know the transfer function of a PLL circuit in detail, and to ascertain that this transfer function is independent of the divide ratio, in order to be able to provide a well balanced design of e.g. a modulator. The present invention thus seeks to provide a phase locked loop circuit, with the desired characteristics.
According to the present invention, a phase locked loop circuit according to the preamble defined above is provided, in which the phase locked loop circuit further comprises a variable gain amplifier positioned in the signal path between the output of the phase comparator and the output of the third transfer block, and in which the gain of the variable gain amplifier is a function of the divide ratio N. In other words, the variable gain amplifier is positioned in the signal path between the phase difference $\theta_D$ and the output signal phase $\theta_O$. This feature linearizes the behavior of the phase locked loop circuit relating the divide ratio to the output phase. As a result, design of systems using such a phase locked loop circuit is easier, as the dynamic behavior of the system remains constant.
In a further embodiment, the variable gain amplifier provides a gain equal to $K_0 \times N$, in which $K_0$ is a constant value. The constant value is a fixed value, independent from N. As a result of this feature, the closed loop transfer function of the PLL circuit (relating the output signal phase $\theta_O$ to the reference signal phase $\theta_R$) is only linearly dependent on N, and the poles and zeroes of the transfer function are at constant locations.
The variable gain amplifier may be incorporated in the first transfer block in a further embodiment, the detector gain being equal to $Kd=Kd_0 \times N$, in which $Kd_0$ is a constant value (again a fixed value, independent from N). In a further embodiment, the variable gain amplifier is incorporated in the third transfer block, the tuning constant being equal to $Kv=Kv_0 \times N$, in which $Kv_0$ is a constant value (again, a fixed value, independent from the divide ratio N).
In a further embodiment, the variable gain amplifier is incorporated in the first transfer block and third transfer block, the detector gain Kd being equal to $Kd=Kd_0 \times N_1$, and the tuning constant Kv being equal to $Kv=Kv_0 \times N_2$, in which $Kd_0$ is a constant value, $Kv_0$ is a constant value and $N_1$ and $N_2$ are predetermined values of which the product $N_1 \times N_2$ equals the divide ratio N. This embodiment allows to split the implementation of the scaling in different subsystems of the PLL circuit, as a result of which the burden on each of the designs may be kept at an acceptable level.
The divide ratio N is, in an even further embodiment, an n-bit binary signal, $N_1$ comprising (n-m) most significant bits of N, and $N_2$ being equal to $N_2 = 2^m$, n and m being integer numbers, and m<n. This approximation may have sufficient accuracy in given applications.

**2**

In further embodiments, the divide ratio N is provided to the phase locked loop circuit as a digital input signal, and the phase locked loop circuit further comprises a digital-to-analog converter (DAC) allowing the provision of the divide ratio N as an analog signal. E.g. the frequency divider may be provided as an N-counter implemented in digital circuitry, allowing the divide ratio to be supplied thereto directly. Other parts of the PLL circuit may require the analog equivalent signal of the divide ratio, which may then be provided as output from the DAC.

As an alternative, the divide ratio N is provided to the phase locked loop circuit as an analog input signal, and the phase locked loop circuit further comprises an analog-to-digital converter (ADC) allowing the provision of the divide ratio N as a digital signal. Again, as required, the divide ratio N or an equivalent signal may be provided in digital or analog form as required by a specific implementation of the PLL circuit.

In a practical implementation, the frequency divider is implemented as an N-counter, the phase comparator is implemented as a phase frequency detector, the first transfer block is implemented as a charge pump, the second transfer block is implemented as a loop filter, and the third transfer block is implemented as a voltage controlled oscillator. All these elements are known as such to the skilled person.

The PLL circuit according to any of the embodiments of the present invention may e.g. be applied in a synthesizer circuit, e.g. a closed loop modulating synthesizer. As the (linear) behaviour of the PLL circuit is accurately known, the design of the entire synthesizer circuit becomes considerably simpler.

## Short description of drawings

The present invention will be discussed in more detail below, using a number of exemplary embodiments, with reference to the attached drawings, in which

Fig. 1 shows a block diagram of a phase locked loop circuit using a charge pump;
Fig. 2 shows a block diagram of a generic phase locked loop (PLL) circuit;
Fig. 3 shows a block diagram of a first embodiment of a PLL circuit according to the present invention;
Fig. 4 shows a block diagram of a second embodiment of a PLL circuit according to the present invention;
Fig. 5 shows a block diagram of a third embodiment of a PLL circuit according to the present invention;
Fig. 6 shows a block diagram of a fourth embodiment of a PLL circuit according to the present invention;
Fig. 7 shows a partial block diagram of a further embodiment for providing the divide ratio both as an analog and a digital signal;
Fig. 8 shows an alternative embodiment for the partial block diagram of Fig. 7; and
Fig. 9 shows a block diagram of a closed loop modulating synthesizer employing a PLL circuit according to the present invention.

## Detailed description of exemplary embodiments

Phase Locked Loop (PLL) systems are used to generate an output signal of which the frequency is a multiple (N, possibly unity) of the frequency of a reference signal. These systems are generally used to track a reference signal e.g. in frequency demodulators or to generate a programmable frequency standard (or local oscillator, LO) from a fixed reference e.g. in synthesizers.

When the output frequency is a multiple of the input frequency, the PLL contains a frequency divider. If such a divider can be programmed to divide by different values, it is generally called an N-Counter, N designating the divide ratio.

When we regard the variable N-value as an input to the PLL system, its transfer function becomes non-linear. The divide ratio enters into the coefficients of the transfer function of the PLL. Not only as a constant gain term, but also in some of the higher order coefficients. This means that the dynamics of the system change for different values of N.

The PLL circuit according to the various embodiments of the present invention cancels the dependency of N in the higher order coefficients, such that the value of N only appears as a constant gain factor. Due to the constant high order coefficients, the dynamics of the system (closed loop frequency response, step response etc.) remain constant.

The invention is beneficial for all PLL systems where an optimization of loop parameters involves finding the worst case condition for N.

In synthesizers the classic problem occurs when the N-Counter is programmed from its minimum to its maximum and back to its minimum value. The step responses for stepping up or down settle to within 1% of their final value in different time intervals, even though the step size is equal.

The present invention is also beneficial for systems that use N as the input and the frequency of the reference signal as a constant, such as closed loop modulating synthesizers. These systems use time-varying values of N to modulate the output frequency. The dependency of the dynamics on N complicate the design of such systems.

Design of PLL systems with a programmable value for N, involves optimization of the loop parameters for a worst case condition. The root-locus method can be used to produce the pole positions of the closed loop system for varying values of N. Subsequently, the loop components are set to such values where the worst case condition meets the specification.

There are PLL systems that use programmable charge pumps for fast locking purposes. These systems switch the charge pump current together with the loop filter time constants in order to temporarily widen the bandwidth of the closed loop system. The variable charge pump is a similar implementation as the invention. In this case, however, it is not scaled with N, but it has two discrete values. Another difference with the invention is that fast locking PLL switches the charge pump current with a different purpose. While the invention aims to make the closed loop transfer function independent of its programmable part, the fast lock principle is aimed at deliberately changing the closed loop transfer function. First to quickly settle to the wanted frequency, subsequently increasing the PLL's selectivity to attenuate unwanted spurious components.

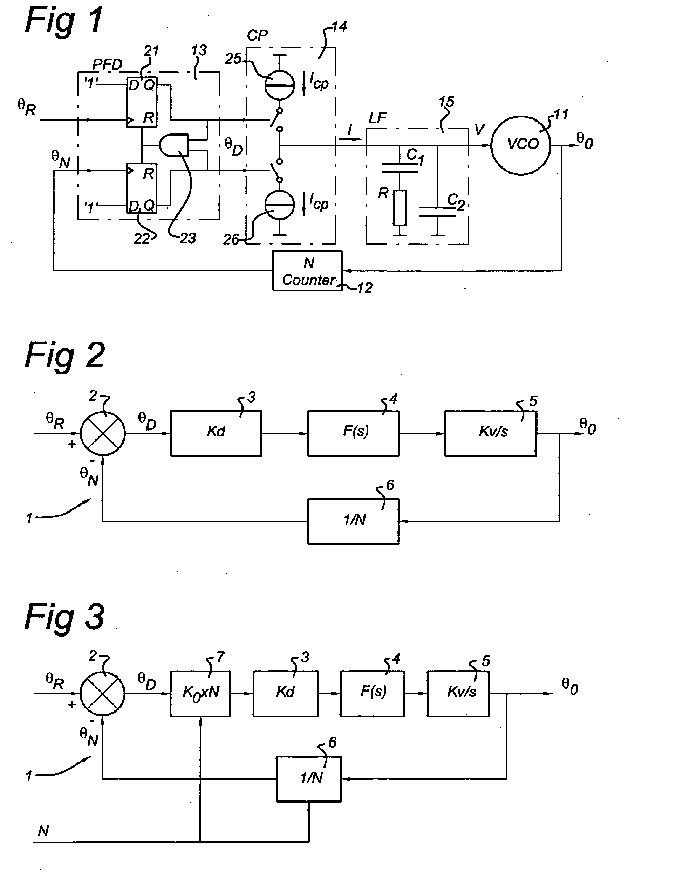

Fig. 1 shows a block diagram of a classic a phase locked loop circuit (PLL) using a charge pump (CP). A reference signal $\theta_R$ and a feedback signal $\theta_N$ are input to a phase frequency detector (PFD) 13. The output of the PFD 13 (phase difference signal $\theta_D$) is fed to a charge pump (CP) 14, the output of which (a current 7) is connected to the input of a loop filter (LF) 15. The output of the LF 15 (a voltage $V$) is input to a voltage controlled oscillator (VCO) 11, which provides an output signal $\theta_0$. The output signal $\theta_O$ is input to an N-counter 12 for providing a divided frequency signal or feedback signal $\theta_N$.

It will be shown that the invention is applicable to all kinds of PLL systems, but this popular one is given as an example. This particular PLL is called a type II system, since it has two ideal integrators in the loop. These two integrators enable the steady state error value to be zero for a unit ramp input signal. A type I system would settle to a unit step input signal with zero error.

The first of these integrators is provided by the VCO 11. The input of the VCO 11 is the voltage V, that linearly influences the frequency of oscillation. The output of the VCO 11 is its phase ($\theta_O$), measured in cycles. Since phase is the primitive of frequency, the first integrator is identified. These cycles can be counted by the N-Counter 12. The application of the CP 14 enables the other ideal integrator without the need for an active loop filter. The total capacitance $C_1+C_2$ in the LF 15 integrates the current I into a voltage V.

The voltage V directly influences the frequency of the VCO 11 and is therefore called the tuning voltage. The frequency sensitivity $dF_{VCO}/dV$ is called Kv and given in Hz/V. There are many ways to construct an oscillator of which the frequency can be controlled by a voltage. Some examples of voltage control include a varactor diode acting as variable capacitor in a resonant circuit, the supply voltage of a ring-oscillator or the comparison voltage of a relaxation oscillator.

The N-Counter 12 divides the VCO frequency by producing one cycle for every N cycles it receives from the VCO 11. This is generally performed by a digital (programmable) counter.

The PFD 13 compares the number of cycles received on its two inputs. The two inputs are formed by the reference input (denoted $\theta_R$) and the feedback input ($\theta_N$) arriving from the N-Counter 12. When the system is in the locked condition, the frequencies of both input signals are equal and their phase difference ($\theta_D$) is zero.

The circuit implementation shown in Fig. 1 of the PFD 13 is of the tri-state type using two D-flipflops 21, 22 and an AND-gate 23, which enables a very large pull-in range. The switches in the CP 14 are closed when the corresponding Q output is logic '1'. This happens when a rising edge is present on either of the clock inputs of the D-flip flops 21, 22 in the PFD 13. When both outputs are logic '1', however, the AND gate 23 resets both flip flops 21, 22 and therefore prevents the occurrence of the '11' output condition, leaving the three states '00', 01' and '10' as valid. The '01' or '10' condition designate the phase difference between reference and feedback signals ($\theta_R$, $\theta_N$), since they are active for the portion of the cycle that the rising edge of one input leads the rising edge of the other input. The pair of output signals use pulse width modulation to carry their information. The pulse width indicating the phase difference ($|\theta_D|$) and the condition '01' or '10' defining its sign.

The output current I of the CP 14 is either 0 (when the PFD output is '00'), +Icp (when it is '10') or -Icp (when it is '01'), using two current sources 25, 26. For the very short time that the (invalid) '11' condition exists to reset the D-flip flops, the output is I = +Icp-Icp which is ideally equal to I = 0.

The loop filter 15 is a trans-impedance circuit, it produces a voltage (V) from a current (I). The transfer function F(s) is given by

$$F(s) = \frac{V(s)}{I(s)} = \frac{1}{C_1+C_2} \cdot \frac{1+sRC_1}{s\left(1+sR\dfrac{C_1C_2}{C_1+C_2}\right)} = \frac{1}{s} \cdot \frac{1}{C_1+C_2} \cdot \frac{1+s\tau_1}{1+s\tau_2}$$

revealing the second ideal integrator as the factor 1/s.

A block diagram of a generic phase locked loop (PLL) circuit 1 is shown schematically in Fig. 2. The block diagram represents a linear system that compares the phases of the input and output signals. All PLL's can be modelled using this linear approximation, provided their comparison frequency is much larger than the closed loop bandwidth of the system. The phase difference signal $\theta_D$ is determined from the reference signal $\theta_R$ and the feedback signal $\theta_N$ using a phase comparator 2. The phase difference signal $\theta_D$ is input to a first transfer block 3 having a detector gain Kd, then to a second transfer block 4 having a transfer function F(s), and then to a third transfer block 5 having a transfer function $\dfrac{Kv}{s}$, Kv being a tuning constant. The output $\theta_O$ of the third transfer block 5 is fed back to the phase comparator 2 via a frequency divider 6 having a divide ratio N.

The parameter Kd is called the detector gain and represents the CP 14 of the implementation of Fig. 1. Its unit is in Amperes/cycle and therefore Kd is equal to Icp for the example of Fig. 1. For systems without a charge pump, the output can be another quantity (e.g. voltage), in which case the LF 15 has no longer a trans-impedance nature. The parameter Kv is called the tuning constant and has the dimension Hertz/Volt. For alternative oscillators (e.g. current controlled) the input quantity would be different but the linear relationship denoted by Kv would still exist. The phases denoted by $\theta$ are all measured in cycles. The summation point or phase comparator 2 is the representation of the PFD 13 of the implementation of Fig. 1. Also this block is generic. As long as the output of this sub-system represents some measure of the phase difference between the two inputs, it can be modelled by a summation point. Popular implementations, such as the mixer and exclusive-or gate, fit this description. The difference between various implementations is their linear input range. This abstraction shows clearly that the example of Fig. 1 is only one implementation of the generic PLL system of Fig. 2. Many implementations for the different blocks 2-6 can be parameterized by this simple block diagram.

The open loop transfer function of the generic PLL from Fig. 2 is given by

$$Ho(s) \;=\; \frac{\theta_N}{\theta_D} \;=\; \frac{KdKvF(s)}{Ns} \qquad \text{Equation (1)}$$

The most general form for the LF 15 transfer function F(s) is given in

$$F(s) \;=\; Kf \cdot \frac{s^{nd} \displaystyle\prod_{i=1}^{nz}(1+s\tau_i)}{s^{ni} \displaystyle\prod_{i=nz+1}^{nz+np}(1+s\tau_i)} \;=\; Kf \cdot \frac{n(s)}{d(s)}$$

where Kf is a constant scaling factor, nd is the number of ideal differentiators, ni is the number of ideal integrators, nz and np are the number of zeroes and poles in the LF 15 respectively, which are not located at the origin of the s-plane. The time constants $\tau_i$ (with $1 \leq i \leq nz+np$) may occur as simple real $\tau_i = 1/\sigma_i$ or complex conjugate pairs $\tau_i = 1/(\sigma_i+j\omega_i)$, $\tau_{i+1} = 1/(\sigma_i-j\omega_i)$, where $s_i = -\sigma_i-j\omega_i$ and $s_{i+1} = -\sigma_i+j\omega_i$ are the roots of the relevant part of the equation.

Ideal differentiators are not helpful in PLL systems, since they cancel out the desired ideal integrators. For completeness we will include nd > 0 as an option in the rest of our calculations. Keep in mind that nd = 0 in practical PLL systems.

For reasons of causality, the order of d(s) must be at least equal to the order of n(s) or nd+nz ≤ ni+np.

Substitution thereof in equation (1) yields the open loop transfer function

$$Ho(s) \;=\; \frac{\theta_N}{\theta_D} \;=\; \frac{KdKvKf \cdot n(s)}{N \cdot s \cdot d(s)}$$

The order of the numerator of Ho(s) is equal to the order of the numerator of F(s) while the order of the denominator of Ho(s) is one higher than that of F(s). The denominator of Ho(s) reveals the order and type of the PLL system. The number of ideal integrators ni+1 sets the type and the number of additional poles sets the order ni+1+np. The simplest PLL system is a 2nd order type I (ni = 0, np = 1, nd = 0, nz = 0). More popular systems have additional poles and integrators.

The loop stability is hampered with large numbers of poles. The phase margin is a simple but reliable stability criterion and is defined by arg $Ho(\omega_u) + \pi$ where $\omega_u$ is the solution for $|Ho(\omega)| = 1$. The phase margin is generally chosen larger than $\pi/4$ for stable and robust operation. The steady state transfer function $Ho(\omega)$ is $Ho(s)$ with $s = j\omega$. The modulus and phase can be expressed as

$$|Ho(\omega)| = \frac{KdKvKf}{N} \cdot \frac{\omega^{nd} \prod\limits_{i=1}^{nz} \sqrt{1 + |\omega\tau_i|^2}}{\omega^{ni+1} \prod\limits_{i=nz+1}^{nz+np} \sqrt{1 + |\omega\tau_i|^2}} \qquad \tau_i = \frac{1}{\sigma_i + j\omega_i}$$

$$\arg Ho(\omega) = \frac{\pi}{2}(nd - ni - 1)\,\text{sgn}\,(\omega) + \sum\limits_{i=1}^{nz} \text{atan}\left(\frac{\omega + \omega_i}{\sigma_i}\right) - \sum\limits_{i=nz+1}^{nz+np} \text{atan}\left(\frac{\omega + \omega_i}{\sigma_i}\right)$$

When, as usual, $\tau i << 1s$ for all i, the modulus of $Ho(\omega)$ is close to $KdKvKf/N$ for $\omega = 1\text{rad/s}$, and decreases (at least globally) for increasing $\omega$. This must always be true, since the order of the denominator is at least 1 higher than the order of the numerator. From the above equation it becomes clear that when $nd-ni-1 \leq -2$, the phase is already less than or equal to $-\pi$ for $\omega = 0$. At least $nz_{min} = \max(ni-nd, 0)$ zeroes are needed with $\tau_i > 1/\omega_u$ to boost the phase at $\omega = \omega_u$ to a value higher than $-3\pi/4$, such that the phase margin is larger than $\pi/4$. Additional poles with $\tau_i < 1/\omega_u$ may be provided to cancel the unwanted gain boost for higher frequencies, caused by the zeroes. This is a popular way to design a PLL but strictly not necessary for the working principle.

From the above we may conclude that for a practical PLL the numbers nd, ni, nz and np are given in the following table:

| Type | nd | ni+1 | nz | np |
|------|----|------|----|----|
| I | 0 | 1 | 0 | ≥0,1 (typical) |
| II | 0 | 2 | 1 | ≥ 0,1 (typical) |
| III | 0 | 3 | 2 | ≥ 0,2 (typical) |

Based on the block diagram of Fig. 2, the closed loop transfer function H(s) is given by

$$H(s) = \frac{\theta_O}{\theta_R} = N \cdot \frac{n(s)}{n(s) + \frac{N}{KdKvKf} \cdot s \cdot d(s)} = N \cdot \frac{s^{nd} \prod\limits_{i=1}^{nz}(1 + s\tau_i)}{s^{nd} \prod\limits_{i=1}^{nz}(1 + s\tau_i) + \frac{N}{KdKvKf} \cdot s^{ni+1} \prod\limits_{i=nz+1}^{nz+np}(1 + s\tau_i)}$$

When we include the practical PLL consideration that nd = 0 and the stability requirement from the table above that nz = ni, we can reduce this equation to

$$H(s) = \frac{\theta_O}{\theta_R} = N \cdot \frac{\prod\limits_{i=1}^{ni}(1 + s\tau_i)}{\prod\limits_{i=1}^{ni}(1 + s\tau_i) + \frac{N}{KdKvKf} \cdot s^{ni+1} \prod\limits_{i=ni+1}^{ni+np}(1 + s\tau_j)}$$

Equation (2)

from which it becomes clear that the highest order of the left member of the denominator is $s^{ni}$, while the lowest order of the right member of the denominator is $s^{ni+1}$. This shows that the multiplication factor N/KdKvKf can be isolated from all coefficients that it occurs in.

For the example of the implementation of Fig. 1, this is

$$H(s) = \frac{\theta_O}{\theta_R} = N \cdot \frac{1 + s\tau_1}{1 + s\tau_1 + \frac{N}{KdKvKf} \cdot s^2(1 + s\tau_2)} = N \cdot \frac{1 + sRC_1}{1 + sRC_1 + s^2\frac{N(C_1 + C_2)}{KdKv} + s^3\frac{NRC_1C_2}{KdKv}} \qquad \text{Eq. (3)}$$

where Kf is replaced by $1/(C_1+C_2)$ to show that Kf depends on $\tau_1$ and $\tau_2$. In general Kf depends both on the poles and the zeroes of the loop filter.

From equation (2) we know that the term N/KdKvKf appears as a multiplier of the coefficients of $s^{ni+1}$ and higher in the denominator of the closed loop transfer function. This means that the pole locations depend on N.

By choosing the N-value as an input variable, the system has become non-linear. The phase signal $\theta_N$ is derived from the output signal $\theta_O$ by division by the input signal N, which is a non-linear operation. It is possible to linearize the system by adding the inverse operation (multiplication with N) somewhere else in the loop. This must be done in the signal path between $\theta_D$ and $\theta_O$ to make sure that the wanted phase relation between $\theta_R$ and $\theta_O$ remains intact.

By adding this multiplication, we make the term N/KdKvKf from equation (2) independent of N.

This can be accomplished by adding a variable gain amplifier (VGA, with gain $K_0 \cdot N$) in the loop. Equation (2) thus changes to

$$H(s) = \frac{\theta_O}{\theta_R} = N \cdot \frac{\prod_{i=1}^{ni}(1 + s\tau_i)}{\prod_{i=1}^{ni}(1 + s\tau_i) + \frac{1}{K_0 KdKvKf} \cdot s^{ni+1} \prod_{i=ni+1}^{ni+np}(1 + s\tau_i)} \qquad \text{Equation (4)}$$

In this way, the term N/KdKvKf = $1/K_0$KdKvKf is a constant. As a result, H(s) is only linearly dependent on N and the poles and zeroes are in constant locations.

The schematic diagrams of Figs. 3-6 show different ways in which the linearization of the transfer function can be implemented. The loop parameters Kd and Kv are the most accessible candidates for scaling, but an additional variable gain amplifier (VGA) 7 with gain value $K_0 \cdot N$ anywhere in the loop between the signals $\theta_D$ and $\theta_O$ is the most general representation of the invention. This representation is shown in the variant of the block diagram in Fig. 3. Note that the VGA 7 may also be positioned between the first and second transfer block 3, 4, between the second and third transfer block 4, 5, or at the output of the third transfer block 5. In the latter case, the output of the VGA 7 would be providing the output signal $\theta_O$ and be connected to the frequency divider 6.

Applications of the VGA 7 would include manipulations of other parameters in the circuit diagram of Fig. 2, e.g. by making Kd or Kv proportional to the divide ratio N. Kf can not be used for this purpose, since it also influences coefficients that do not depend on the divide ratio N. The additional loop parameter can be combined with the product KdKv in the transfer function as shown in equation (4), so it is essentially the same as scaling with either of these parameters. The next examples show the more practical applications of the invention by scaling Kd, Kv or a combination of the two.

As an implementation example, we could make the charge pump current dependent on N, say Kd = Kd(N) = $Kd_0 \cdot N$, the ratio N/Kd would remain constant. Equation (4) thus changes to

$$H(s) = \frac{\theta_O}{\theta_R} = N \cdot \frac{\prod_{i=1}^{ni}(1 + s\tau_i)}{\prod_{i=1}^{ni}(1 + s\tau_i) + \frac{1}{Kd_0 KvKf} \cdot s^{ni+1} \prod_{i=ni+1}^{ni+np}(1 + s\tau_i)}$$

or the example of Fig. 1 as was earlier expressed in equation (3), now changes to

$$H(s) = \frac{\theta_O}{\theta_R} = N \cdot \frac{1 + sRC_1}{1 + sRC_1 + s^2\dfrac{C_1 + C_2}{Kd_0 Kv} + s^3\dfrac{RC_1 C_2}{Kd_0 Kv}} \qquad Kd = N \cdot Kd_0$$

<div align="right">Equation 5</div>

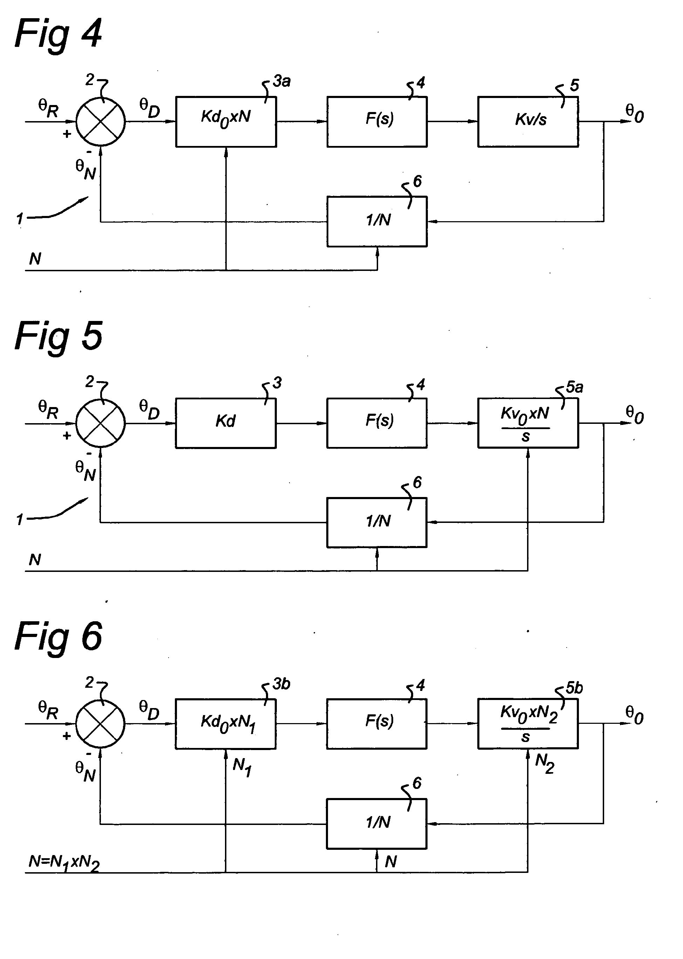

The corresponding block diagram of the PLL circuit 1 is shown in Fig. 4, in which the first transfer block 3a now has a detector gain equal to $Kd_0 \cdot N$.

An alternative implementation would be to scale Kv with N, $Kv = Kv(N) = Kv_0 \cdot N$. The corresponding block diagram of the PLL circuit 1 is shown in Fig. 5, in which the third transfer block 5a now has a tuning constant Kv equal to $Kv_0 \cdot N$.

Scaling of the loop filter voltage V from Fig. 1 is also possible, e.g. by potential division. Such an action can easily be rewritten as scaling of Kv.

The invention covers all means to add $K_0$, or that can be considered to be scaling of Kd or Kv or a combination of the two, independent of their implementation.

If the range of N values does not contain primes, it could also be beneficial to split the n-bit binary representation of N up into $N_1$ and $N_2$ (and possibly even $N_3$, if an additional VGA is used), each of which need less than n bits. The predetermined factors must then obey $N = N_1 \cdot N_2$ (or $N = N_1 \cdot N_2 \cdot N_3$). As an example the range of N-values from 24 to 28 can be converted as shown in the following table:

| N | | $N_1$ | | $N_2$ | |
|---|---|---|---|---|---|
| decimal | binary | decimal | binary | decimal | binary |
| 24 | 10111 | 8 | 111 | 3 | 0010 |
| 25 | 11000 | 5 | 100 | 5 | 0100 |
| 26 | 11001 | 2 | 001 | 13 | 1100 |
| 27 | 11010 | 3 | 010 | 9 | 1000 |
| 28 | 11011 | 4 | 011 | 7 | 0110 |

Note that the binary representation of $N = 1$ is 0 (or more general $N$-1), since $N = 0$ is not allowed. When the implementation of the scaling can be split up into different sub-systems, the burden on each of the designs could be kept at an acceptable level.

An example of a block diagram of a PLL circuit 1 using such a division over two circuit parameters is shown in Fig. 6, in which the first transfer block 3b now has a detector gain of $Kd_0 \cdot N_1$, and the third transfer block 5b now has a tuning constant Kv equal to $Kv_0 \cdot N_2$.

Another way to reduce circuit complexity is to implement only the (n-m) most significant bits of N as $N_1$ ($N_1 = int(N/2^m)$, while fixing $N_2$ at $2^m$ ('int' being a function providing the nearest lower integer number). In this case actually the situation of Fig. 4 is recreated. The value of Kv is in this case a constant ($Kv = Kv_0 \cdot 2^m = Kv_0 \cdot N_2$) and $Kd = Kd_0 \cdot int(N/2^m) = Kd_0 \cdot N_1$. The product $Kv \cdot Kd$ is then $Kv_0 \cdot 2^m \cdot Kd_0 \cdot int(N/2^m) \approx Kv_0 \cdot Kd_0 \cdot N$. The linearization is now only approximate, but might be sufficient for the given application. Of course this can also be accomplished by using $K = K_0 \cdot 2^m \cdot int(N/2^m) \approx K_0 \cdot N$ in the embodiment of Fig. 3 or $Kv = Kv_0 \cdot 2^m \cdot int(N/2^m) \approx Kv_0 \cdot N$ in the embodiment of Fig. 5.

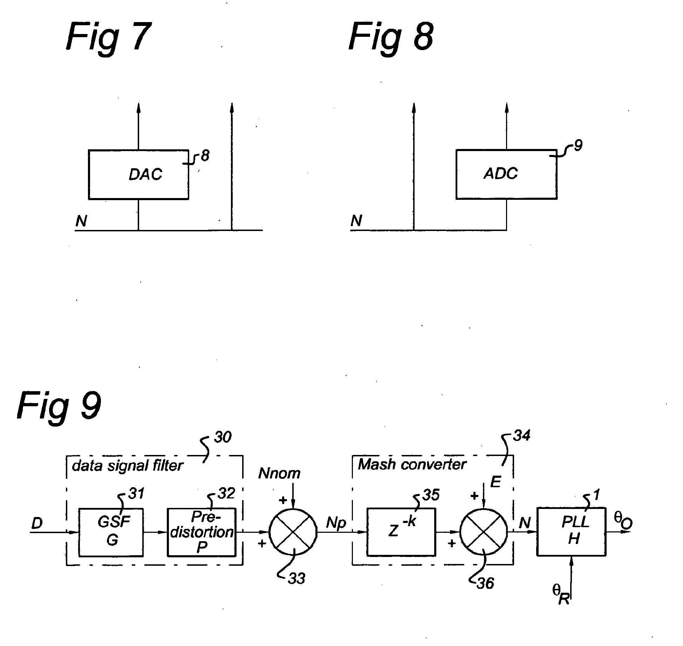

Since the N-Counter 6 will be a digital counter in most cases, the value of divide ratio N will be available as a binary number. The implementation of the scaling will therefore preferably have a digital to analogue converter (DAC) nature, as shown in the schematic partial diagram of Fig. 7, in which a DAC 8 is provided to also make available an analog signal representing the divide ratio N. As an alternative, the value of divide ratio N can of course be available as an analogue signal. In this case an analogue to digital converter (ADC) would be needed, e.g. at the N-input of the N-Counter 12, where the scaling can be done by analogue multipliers. Fig. 8 shows a schematic partial diagram, in which a ADC 9 is present to provide the digital representation of the divide ratio N.

In the exemplary implementation of Fig. 1, the CP 14 must provide a current scaling operation, which can be implemented as a current mode DAC: Binary scaled current sources switched in and out depending on the binary representation of N.

When no CP 14 is present (in another implementation of a PLL circuit as discussed above) the output of the PFD 13 could be a voltage, in which case it could be done with a voltage mode DAC.

When the scaling is done in the VCO 11, a frequency sensitive parameter must be scaled. This could be implemented in an LC oscillator as a binary scaled varactor diode. Its reverse bias is set by the voltage V as indicated in Fig. 1. The binary representation of N switches parts of the varactor diode in parallel with an inductor to set the frequency of oscillation.

In a relaxation type oscillator, the current that is integrated in a fixed capacitor can be modulated using a programmable current mirror. Or the reference voltage difference that sets the comparator levels may be scaled with N, using a voltage mode DAC.

When there is just one control input to the VCO 11, the range and resolution can be adapted to include the scaling with N. Examples are a ring-oscillator where the supply sets the frequency, or a direct digital sequence (DDS look up table) where the increment in the address represents the phase increment.

The direct benefit of the invention is found in systems where the PLL closed loop transfer function must be accurately known. An example of such a system is a closed loop modulating synthesizer. The following description of that system is based on a DECT transmitter and its block diagram is shown in Fig. 9. Any phase or frequency modulating scheme can be used in this architecture.

This transmitter must represent a data signal D with some required pulse shaping (G) as the frequency modulation of the local oscillator signal ($\theta_O$). The data signal D is input to a data signal filter 30, comprising a pulse shaping block 31 having a pulse shaping function G (or Gaussian Shaped Filter GSF) followed by a predistortion block 32 having a predistortion function (P). The output of the predistortion block 32 is added to a nominal divide ratio value Nnom using a first adder 33, resulting in a signal Np. The signal Np is used as input for a Sigma-Delta ($\Sigma\Delta$) modulator of order k, in this case implemented as a multi stage noise shaping (MASH) converter 34, the behaviour of which can be modelled as a delay line 35 for delaying the signal Np by k samples. In the block diagram of Fig. 9, the addition of quantization noise E in this process is shown as a second adder 36, producing as output a signal N, which is the momentary N-value. This signal N is then used as input for a PLL circuit 1, which is further receiving a reference signal $\theta_R$ with a constant frequency $f_R$, for producing the output signal $\theta_O$ with a modulation dependent on the data signal D.

The PLL circuit 1 is shown in Fig. 9 as a block with inputs $\theta_R$ and N and output $\theta_O$. The reference signal $\theta_R$ has a constant frequency ($f_R$) which may be regarded as a constant parameter. The actual input of the PLL circuit 1 is the momentary N-value. Therefore the closed loop transfer function from equation (5) above is rewritten to

$$H(s) = \frac{\theta_O}{N} = \frac{f_R}{s} \cdot \frac{1 + sRC_1}{1 + sRC_1 + s^2\frac{C_1 + C_2}{Kd_0 Kv} + s^3\frac{RC_1 C_2}{Kd_0 Kv}} \qquad Kd = N \cdot Kd_0$$

with the substitution $\theta_R = f_R/s$. The frequency relation is shown by taking the derivative

$$Hf(s) = \frac{f_O}{N} = f_R \cdot \frac{1 + sRC_1}{1 + sRC_1 + s^2\frac{C_1 + C_2}{Kd_0 Kv} + s^3\frac{RC_1 C_2}{Kd_0 Kv}} \qquad Kd = N \cdot Kd_0$$

showing only constant coefficients in the transfer function relating output frequency to N.

This N-value is a digital representation of the nominal divide ratio (Nnom, setting the channel frequency Nnom·$f_R$) and the filtered data signal (D). This value is produced by a $k^{th}$ order $\Sigma\Delta$- modulator 34.

The purpose of the $\Sigma\Delta$-modulator 34 is to round Np (possibly rational) to a sequence of integer divide ratios N. It changes the input from a slow varying, low amplitude signal to a fast varying large amplitude signal, containing the same information. Unfortunately this can not be achieved without producing additional quantization noise (E).

The $\Sigma\Delta$-modulator 34 of Fig. 9 is depicted as a multi stage noise shaping (MASH) converter in forward Euler configuration. This means that the signal is delayed by k samples where k is the order of the $\Sigma\Delta$-modulator 34. The uniform quantization noise is filtered by k ideal differentiators. This means that there is hardly any noise power in the low frequency range, where the wanted information is located but the noise density rises with 20k dB/decade for increasing frequency.

The high frequency noise will be filtered by the noise transfer function $\theta_O$/E, i.e. the PLL dynamics (H). When the closed loop bandwidth of H is small, the low frequency content in N is visible as the modulation of the LO signal ($\theta_O$).

There is a drawback to decreasing the closed loop bandwidth of H. Since it is also part of the signal transfer function $\theta_O$/D = G.P.H, it also limits the bandwidth available to D. This bandwidth must ideally be set by the required Gaussian Shaped Filter (G) 31. In order to reach this bandwidth, the pre-distortion filter 32 can be used P = $f_R$/Hf, representing the inverse of the normalised closed loop transfer function. When such a filter is in place, the dynamics of the PLL indeed filter the noise E, but cancel out of the signal transfer function G.P.H = G·$\theta_R$.

Generally, the Data Signal Filter 30 will be constructed as a digital circuit. The pre-distortion filter (P) 32 must be an accurate representation of its ideal. The PLL circuit 1 can be described (as is done here) as a continuous-time system. The pulse width modulated signal produced by the PFD 13 is treated as a continuous wave, although it is better approximated as a sampled data signal. The complete PLL is therefore a mixed mode system, which inverse can only be approximated to a certain extend by a digital filter. The realisation of the system of Fig. 9 is easier when the transfer function H is independent of N, which is enabled by the PLL circuit implementations according to the present invention.

Other benefits of this invention are the elimination of the worst case problem. Since the PLL dynamics are constant for all values of N, a PLL system can be designed using a typical case. There is no need to vary design parameters to cover the complete design space, which speeds up the design process and eliminates the need for over-designing in one situation to accommodate the specification in the worst case situation.

The present invention has been described in detail using a number of exemplary embodiments with reference to the drawings. For the person skilled in the art it will be apparent that alternatives and modifications may be made to elements of the implementations as described. The implementations as described are meant as examples of the present invention and are not intended to limit the scope of protection of the present invention, which is defined by the appended Claims.

## Claims

1. Phase locked loop circuit (1) for relating a reference signal phase $\theta_R$ with an output signal phase $\theta_O$, comprising

   a frequency divider (6) receiving the output signal as input and providing a divided frequency signal with a divided frequency signal phase $\theta_N$ as output using a divide ratio N, N being a rational number,

   a phase comparator (2) for providing a phase difference $\theta_D$ between the reference signal phase $\theta_R$ and the divided frequency signal phase $\theta_N$,

   a first transfer block (3) having a detector gain Kd receiving the phase difference $\theta_D$ as input, a second transfer block (4) having a transfer function F(s) connected to the first transfer block (3), and a third transfer block (5) having a transfer function equal to $\dfrac{Kv}{s}$ and connected to the second transfer block (4) for outputting the output signal

   phase $\theta_O$, Kv being a tuning constant,

   **characterised in that** the phase locked loop circuit (1) further comprises a variable gain amplifier (7) positioned in the signal path between the output of the phase comparator (2) and the output of the third transfer block (5), and **in that** the gain of the variable gain amplifier is a function of the divide ratio N.

2. Phase locked loop circuit according to claim 1, in which the variable gain amplifier (7) provides a gain equal to $K_0 \times N$, in which $K_0$ is a constant value.

3. Phase locked loop circuit according to claim 1, in which the variable gain amplifier (7) is incorporated in the first transfer block (3a), the detector gain being equal to $Kd = Kd_0 \times N$, in which $Kd_0$ is a constant value.

4. Phase locked loop circuit according to claim 1, in which the variable gain amplifier (7) is incorporated in the third transfer block (5a), the tuning constant being equal to $Kv = Kv_0 \times N$, in which $Kv_0$ is a constant value.

5. Phase locked loop circuit according to claim 1, which the variable gain amplifier (7) is incorporated in the first transfer block (3b) and third transfer block (5b), the detector gain Kd being equal to $Kd = Kd_0 \times N_1$, and the tuning constant Kv being equal to $Kv = Kv_0 \times N_2$, in which $Kd_0$ is a constant value, $Kv_0$ is a constant value and $N_1$ and $N_2$ are predetermined values of which the product $N_1 \times N_2$ equals the divide ratio N.

6. Phase locked loop circuit according to claim 5, in which the divide ratio N is an n-bit binary signal, $N_1$ comprising (n-m) most significant bits ofN, and $N_2$ being equal to $N_2 = 2^m$, n and m being integer numbers, and m<n.

7. Phase locked loop circuit according to any one of claims 1-5, in which the divide ratio N is provided to the phase locked loop circuit (1) as a digital input signal, and the phase locked loop circuit further comprises a digital-to-analog converter (8) allowing the provision of the divide ratio N as an analog signal.

8. Phase locked loop circuit according to any one of claims 1-7, in which the divide ratio N is provided to the phase locked loop circuit (1) as an analog input signal, and the phase locked loop circuit further comprises an analog-to-digital converter (9) allowing the provision of the divide ratio N as a digital signal.

9. Phase locked loop circuit according to any one of claims 1-8, in which in which the frequency divider (6) is implemented as an N-counter (12), the phase comparator (2) is implemented as a phase frequency detector (13), the first transfer block (3) is implemented as a charge pump (14), the second transfer block (4) is implemented as a loop filter (15), and the third transfer block (5) is implemented as a voltage controlled oscillator (11).

10. Synthesizer circuit comprising a phase locked loop circuit (1) according to any one of claims 1-9.

**Patentansprüche**

1. Phasenregelschaltkreis (1) zum Zuordnen einer Referenzsignalphase $\theta_R$ zu einer Ausgangssignalphase $\theta_O$, umfassend:

   einen Frequenzteiler (6), der das Ausgangssignal als Eingabe empfängt und ein Frequenzteilungssignal mit einer Frequenzteilungssignalphase $\theta_N$ als Ausgabe vorsieht, unter Verwendung eines Teilungsverhältnisses N, wobei N eine rationale Zahl ist,
   einen Phasenkomparator (2) zum Vorsehen einer Phasendifferenz $\theta_D$ zwischen der Referenzsignalphase $\theta_R$ und der Frequenzteilungssignalphase $\theta_N$,
   einen ersten Übertragungsblock (3) mit einem Detektorverstärkungsfaktor Kd, der die Phasendifferenz $\theta_D$ als Eingabe empfängt, einen zweiten Übertragungsblock (4) mit einer Übertragungsfunktion F(s), der mit dem ersten Übertragungsblock (3) verbunden ist, sowie einem dritten Übertragungsblock (5), der eine Übertragungsfunktion Kv/s aufweist und mit dem zweiten Übertragungsblock (4) verbunden ist, um die Ausgangssignalphase $\theta_O$ auszugeben, wobei Kv eine Verstimmungskonstante ist,
   **dadurch gekennzeichnet, dass** der Phasenregelschaltkreis (1) ferner einen Verstärker (7) mit variablen Verstärkungsfaktor umfasst, der in dem Signalpfad zwischen dem Ausgang des Phasenkomparators (2) und dem Ausgang des dritten Übertragungsblocks (5) angeordnet ist, und **dadurch** dass der Verstärkungsfaktor des Verstärkers mit variablem Verstärkungsfaktor eine Funktion des Teilungsverhältnisses N ist.

2. Phasenregelschaltkreis nach Anspruch 1, wobei der Verstärker (7) mit variablem Verstärkungsfaktor einen Verstärkungsfaktor gleich $K_0 \times N$ vorsieht, wobei $K_0$ ein konstanter Wert ist.

3. Phasenregelschaltkreis nach Anspruch 1, wobei der Verstärker (7) mit variablem Verstärkungsfaktor in dem ersten Übertragungsblock (3a) aufgenommen ist, wobei der Detektorverstärkungsfaktor gleich $Kd = Kd_0 \times N$ ist, wobei $Kd_0$ ein konstanter Wert ist.

4. Phasenregelschaltkreis nach Anspruch 1, wobei der Verstärker (7) mit variablem Verstärkungsfaktor in dem dritten Übertragungsblock (5a) aufgenommen ist, wobei die Verstimmungskonstante gleich $Kv = Kv_0 \times N$ ist, wobei $Kd_0$ ein konstanter Wert ist.

5. Phasenregelschaltkreis nach Anspruch 1, wobei der Verstärker (7) mit variablem Verstärkungsfaktor in dem ersten Übertragungsblock (3b) und dem dritten Übertragungsblock (5b) aufgenommen ist, wobei der direkte Verstärkungsfaktor Kd gleich $Kd = Kd_0 \times N_1$ ist, und die Verstimmungskonstante Kv gleich $Kv = Kv_0 \times N_2$ ist, wobei $Kd_0$ ein konstanter Wert ist, $Kv_0$ ein konstanter Wert ist und $N_1$ sowie $N_2$ vorbestimmte Werte sind, deren Produkt $N_1 \times N_2$ gleich dem Teilungsverhältnis N ist.

6. Phasenregelschaltkreis nach Anspruch 5, wobei das Teilungsverhältnis N ein Binärsignal mit n-Bit ist, wobei $N_1$ (n-m) führende Bits von N umfasst, wobei $N_2$ gleich $N_2 = 2^m$ ist, n und m ganzzahlige Zahlen sind und m < n ist.

7. Phasenregelschaltkreis nach einem der Ansprüche 1-5, wobei das Teilungsverhältnis N dem Phasenregelschaltkreis (1) als digitales Eingabesignal bereitgestellt wird, und der Phasenregelschaltkreis ferner einen Digital/AnalogWandler (8) umfasst, der das Vorsehen des Teilungsverhältnisses N als analoges Signal ermöglicht.

8. Phasenregelschaltkreis nach einem der Ansprüche 1-7, wobei das Teilungsverhältnis N dem Phasenregelschaltkreis (1) als ein analoges Eingangssignal bereitgestellt wird, und der Phasenregelschaltkreis ferner einen Analog/Digital-Wandler (9) umfasst, der das Vorsehen des Teilungsverhältnisses N als ein digitales Signal ermöglicht.

9. Phasenregelschaltkreis nach einem der Ansprüche 1-8, wobei in dieser der Frequenzteiler (6) als ein N-Zähler (12) realisiert ist, der Phasenkomparator (2) als Phasenfrequenzdetektor (13) realisiert ist, der erste Übertragungsblock (3) als Ladungspumpe (14) realisiert ist, der zweite Übertragungsblock (4) als ein Schleifenfilter (15) realisiert ist, und der dritte Übertragungsblock (5) als ein spannungsgesteuerter Oszillator (11) realisiert ist.

10. Synthesizerschaltung mit einem Phasenregelschaltkreis (1) gemäß einem der Ansprüche 1-9.

**Revendications**

1. Circuit à boucle à verrouillage de phase (1) pour relier une phase de signal de référence $\theta_R$ à une phase de signal de sortie $\theta_O$, comportant

   un diviseur de fréquence (6) recevant le signal de sortie en tant qu'entrée et fournissant un signal à fréquence divisée avec une phase de signal à fréquence divisée $\theta_N$ en tant que sortie utilisant un rapport de division N, N étant un nombre rationnel,

   un comparateur de phase (2) pour fournir un déphasage $\theta_D$ entre la phase de signal de référence $\theta_R$ et la phase de signal à fréquence divisée $\theta_N$,

   un premier bloc de transfert (3) ayant un gain de détecteur Kd recevant le déphasage $\theta_D$ en tant qu'entrée, un deuxième bloc de transfert (4) ayant une fonction de transfert F(s) connectée au premier bloc de transfert (3), et un troisième bloc de transfert (5) ayant une fonction de transfert égale à $\dfrac{Kv}{s}$ et connectée au deuxième bloc de transfert (4) pour générer en sortie la phase de signal de sortie $\theta_O$, Kv étant une constante de syntonisation,
   **caractérisé en ce que** le circuit à boucle à verrouillage de phase (1) comprend en outre un amplificateur de gain variable (7) positionné sur le trajet de signal entre la sortie du comparateur de phase (2) et la sortie du troisième bloc de transfert (5), et **en ce que** le gain de l'amplificateur de gain variable est en fonction du rapport de division N.

2. Circuit à boucle à verrouillage de phase selon la revendication 1, dans lequel l'amplificateur de gain variable (7) délivre un gain égal à $K_0 \times N$, dans lequel $K_0$ est une valeur constante.

3. Circuit à boucle à verrouillage de phase selon la revendication 1, dans lequel l'amplificateur de gain variable (7) est incoporé dans le premier bloc de transfert (3a), le gain de détecteur étant égal à $Kd = Kd_0 \times N$, dans lequel $Kd_0$ est une valeur constante.

4. Circuit à boucle à verrouillage de phase selon la revendication 1, dans lequel l'amplificateur de gain variable (7) est incoporé dans le troisième bloc de transfert (5a), la constante de syntonisation étant égale à $Kv = Kv_0 \times N$, où $Kv_0$ est une valeur constante.

5. Circuit à boucle à verrouillage de phase selon la revendication 1, dans lequel l'amplificateur de gain variable (7) est incoporé dans le premier bloc de transfert (3b) et dans le troisième bloc de transfert (5b), le gain de détecteur Kd étant égal à $Kd = Kd_0 \times N_1$, et la constante de syntonisation Kv étant égale à $Kv = Kv_0 \times N_2$, où $Kd_0$ est une valeur constante, $Kv_0$ est une valeur constante et $N_1$ et $N_2$ sont des valeurs prédéterminées dont le produit $N_1 \times N_2$ est égal au rapport de division N.

6. Circuit à boucle à verrouillage de phase selon la revendication 5, dans lequel le rapport de division N est un signal binaire à n bits, $N_1$ comportant (n-m) bits les plus significatifs de N, et $N_2$ étant égale à $N_2 = 2^m$, n et m étant des nombres entiers, et m < n.

7. Circuit à boucle à verrouillage de phase selon l'une quelconque des revendications 1 à 5, dans lequel le rapport de division N est fourni au circuit à boucle à verrouillage de phase (1) en tant qu'un signal d'entrée numérique, et le circuit à boucle à verrouillage de phase comporte en outre un convertisseur numérique - analogique (8) permettant la fourniture du rapport de division N en tant qu'un signal analogique.

8. Circuit à boucle à verrouillage de phase selon l'une quelconque des revendications 1 à 7, dans lequel le rapport de division N est fourni au circuit à boucle à verrouillage de phase (1) en tant qu'un signal d'entrée analogique, et le circuit à boucle à verrouillage de phase comporte en outre un convertisseur analogique - numérique (9) permettant la fourniture du rapport de division N en tant qu'un signal numérique.

9. Circuit à boucle à verrouillage de phase selon l'une quelconque des revendications 1 à 8, dans lequel le diviseur de fréquence (6) est mis en oeuvre en tant qu'un compteur N (12), le comparateur de phase (2) est mis en oeuvre en tant qu'un détecteur de fréquence de phase (13), le premier bloc de transfert (3) est mis en oeuvre en tant qu'une pompe à charge (14), le deuxième bloc de transfert (4) est mis en oeuvre en tant qu'un filtre à boucle (15), et le troisième bloc de transfert (5) est mis en oeuvre en tant qu'un oscillateur à tension asservie (11).

10. Circuit de synthétiseur comportant un circuit à boucle à verrouillage de phase (1) selon l'une quelconque des revendications 1 à 9.

## Fig 1

## Fig 2

## Fig 3

## Fig 4

## Fig 5

## Fig 6

# Fig 7

# Fig 8

# Fig 9

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2004051854 A
- US 2006139109 A